# EUROPÄISCHE PATENTANMELDUNG

(11) **EP 4 280 096 A1**
(43) Veröffentlichungstag der Anmeldung: **22.11.2023**
(21) Anmeldenummer: 22174176.2
(22) Anmeldetag: 18.05.2022
(51) Int. Cl.: G06F 30/27, G07C 9/00

(54) **VERFAHREN ZUM ERZEUGEN VON VERÄNDERUNGSVORSCHLÄGEN, BETREFFEND EINE ODER MEHRERE ZUTRITTSKOMPONENTEN EINES ZUTRITTSSYSTEMS; COMPUTERSYSTEM; TRAININGSDATEN; COMPUTERPROGRAMMPRODUKT**

(71) Anmelder: dormakaba Schweiz AG, 8153 Rümlang (CH)
(72) Erfinder: Rappel, Christian, 8620 Wetzikon (CH); Bradfisch, Alexander, 58256 Ennepetal (DE)
(74) Vertreter: Balder IP Law, S.L.

(57) **Zusammenfassung**

Die Erfindung betrifft ein Verfahren zum Erzeugen von Veränderungsvorschlägen, betreffend eine oder mehrere Zutrittskomponenten eines Zutrittssystems, mithilfe eines ML-Systems,
wobei das Verfahren zum Erzeugen von Veränderungsvorschlägen umfasst:
--- a1) Erhalten von Plan-Daten einer Immobilie, aufweisend mindestens ein Zutrittssystem, durch das ML-System,
wobei das Zutrittssystem eine Kombination von Zutrittskomponenten aufweist,
--- a2) Analysieren der Plan-Daten mithilfe des ML-Systems zum Erzeugen von mindestens einem Veränderungsvorschlag, betreffend eine oder mehrere der Zutrittskomponenten des mindestens einen Zutrittssystems.

## Beschreibung

Die vorliegende Erfindung betrifft ein Verfahren zum Erzeugen von Veränderungsvorschlägen, betreffend eine oder mehrere Zutrittskomponenten eines Zutrittssystems. Ferner betrifft die Erfindung ein Verfahren zum Trainieren eines ML (machine learning)-Systems, sowie ein Computersystem, Trainingsdaten und ein Computerprogrammprodukt.

Zutrittssysteme, insbesondere Türsysteme, werden in oder an Gebäuden oder Arealen verwendet, um den Zutritt zu bestimmten Bereichen und Räumen zu steuern oder zu beschränken und einzelne Bereiche und Räume vom übrigen Gebäude oder Areal abzugrenzen. Zutrittskomponenten können als Teile solcher Zutrittssysteme vielseitige Funktionen übernehmen, die häufig einer elektrischen Steuerung bedürfen, beispielsweise automatische Öffnungs- oder Schließfunktionen, Sicherheitsfunktionen, Alarmfunktionen und Schlossfunktionen. Ferner bestehen für die einzelnen Komponenten von Zutrittssystemen auch mechanische Wechselwirkungen und die Komponenten sind bezüglich ihrer Größe und Ausdehnung aufeinander abgestimmt.

Bei Bestandsimmobilien, beispielsweise bei Brownfield-Immobilien, kommt es vor, dass Kombinationen von Zutrittskomponenten als Teil von Zutrittssystemen verbaut sind, die nicht optimal aufeinander abgestimmt sind oder bei denen Probleme durch die spezifische Kombination von verbauten Zutrittskomponenten auftreten können. Beispielsweise kann es sein, dass ein bestimmter Antriebsmotor für einen Türflügel mit einem bestimmten Türflügeltyp kombiniert ist, die nicht optimal zueinander passen, was zu einer erhöhten Fehleranfälligkeit oder einem erhöhten Wartungsbedarf führen kann. Solche Probleme sind auch für geschultes Fachpersonal häufig nicht unmittelbar ersichtlich, sodass derartige Probleme bei Bestandimmobilien bzw. in der Änderungsplanung von Bestandsimmobilien häufig nicht erkannt werden und unberücksichtigt bleiben. Auch bei der Planung von Neubauten oder neuen Zutrittssystemen für bestehende Immobilen kann es vorkommen, dass Kombinationen von Zutrittskomponenten gewählt werden, die in der Praxis eine erhöhte Fehleranfälligkeit oder eine erhöhte Abnutzung aufweisen.

Vor diesem Hintergrund stellt sich die Aufgabe, ein vorteilhaftes Verfahren zum Bereitstellen von Veränderungsvorschlägen, betreffend eine oder mehrere Zutrittskomponenten eines Zutrittssystems, bereitzustellen, mit dem vorzugsweise eine Fehleranfälligkeit, ein Wartungsaufwand oder Kosten reduziert werden können.

Die Aufgabe wird erfindungsgemäß gelöst durch ein Verfahren zum Erzeugen von Veränderungsvorschlägen, betreffend eine oder mehrere Zutrittskomponenten eines Zutrittssystems, mithilfe eines ML-Systems (Machine learning-System),
wobei das Verfahren zum Erzeugen von Veränderungsvorschlägen umfasst:
--- a1) Erhalten von Plan-Daten einer Immobilie, aufweisend mindestens ein Zutrittssystem, durch das ML-System, wobei das Zutrittssystem eine Kombination von Zutrittskomponenten aufweist,
--- a2) Analysieren der Plan-Daten mithilfe des ML-Systems zum Erzeugen von mindestens einem Veränderungsvorschlag, betreffend eine oder mehrere der Zutrittskomponenten des mindestens einen Zutrittssystems.

Erfindungsgemäß kann somit eine vorteilhafte Analyse der in Kombination verwendeten Zutrittskomponenten eines Zutrittssystems durch ein trainiertes ML-System erfolgen, das vorzugsweise zur Erkennung von möglichen Problemen oder Fehlern, die für bestimmte Kombinationen von Zutrittskomponenten auftreten können, konfiguriert ist. Es können somit Veränderungsvorschläge durch das ML-System bereitgestellt werden, die eine Optimierung der in Kombination verwendeten Zutrittskomponenten eines Zutrittssystems ermöglichen. Beispielsweise können Vorschläge, die den Austausch einzelner Zutrittskomponenten eines Zutrittssystems oder eine Anpassung von Betriebsparametern von einzelnen Zutrittskomponenten eines Zutrittssystems betreffen, bereitgestellt werden, die eine Lebenszeitverlängerung des Zutrittssystems oder eine Verringerung des Wartungsaufwands ermöglichen. Hierdurch kann eine besonders vorteilhafte und effektive Änderungsplanung für Bestandsimmobilien erreicht werden.

Das erfindungsgemäße Verfahren zum Erzeugen von Veränderungsvorschlägen kann auch als Verfahren zum Bereitstellen von Veränderungsvorschlägen verstanden werden.

Das ML-System hat vorzugsweise Zugriff auf einen Datensatz, aufweisend Spezifikationen und/oder Informationen zu einer Vielzahl von Zutrittskomponenten, und kann auf Grundlage dieses Datensatzes in Schritt a2) Vorschläge erzeugen.

Die Plan-Daten geben vorzugsweise die Zutrittskomponenten an, die in Kombination das zumindest eine Zutrittssystem der Immobilie bilden. Es ist denkbar, dass die Plan-Daten auch die Zutrittskomponenten weiterer Zutrittssystem der Immobilie angeben. Die Plan-Daten können dem ML-System in Schritt a1) beispielsweise durch eine Person und/oder ein Computerprogramm bereitgestellt werden. Die Plan-Daten können Informationen zu den in der Immobilie vorhandenen Zutrittssystemen umfassen. Vorzugsweise umfassen die Plan-Daten Informationen, die die in Kombination verwendeten Zutrittskomponenten eines Zutrittssystems angeben. Die Immobilie umfasst vorzugsweise ein Gebäude und/oder Areal. Die Plan-Daten umfassen insbesondere einen Gebäude- und/oder Areal-Plan. Die Plan-Daten können beispielsweise einen Plan, aufweisend Informationen der technischen Gebäudeausrüstung (TGA) des Gebäudes und/oder Areals, und/oder einen Schließplan umfassen. Die Plan-Daten sind insbesondere computerimplementierte Daten. Es ist denkbar, dass die Plan-Daten mithilfe einer Datenbank ausgebildet sind. Es ist denkbar, dass die Plan-Daten als digitaler Datensatz verstanden werden können, der Informationen zu dem Gebäude und/oder Areal umfasst. Es ist denkbar, dass die Plan-Daten in Form von Tabellen oder Registern hinterlegt sind.

Es ist denkbar, dass das ML-System zum Analysieren der Plan-Daten eine Erkennungs-Engine aufweist, die zur Identifizierung von Zutrittskomponenten und/oder Zutrittssystemen in den Plan-Daten konfiguriert ist. In diesem Fall ist es denkbar, dass die Plan-Daten Messdaten, beispielsweise Fotos oder Videos, aufweisen, die von einem Zutrittssystem einer Immobilie gemacht wurden. Die Erkennungs-Engine ist zur Erkennung der in Kombination vorhandenen Zutrittskomponenten des Zutrittssystem in derartigen Plan-Daten, beispielsweise in Fotos oder Videos, konfiguriert. Es ist denkbar, dass die Erkennungs-Engine derart trainiert ist, dass sie zur Erkennung von Zutrittskomponenten in den Messdaten konfiguriert ist. Alternativ oder zusätzlich ist es denkbar, dass die Plan-Daten Strichzeichnungen, Simulationsdarstellungen und/oder Grafiken von dem Zutrittssystem und/oder den vorhandenen Zutrittskomponenten aufweisen. Alternativ oder zusätzlich ist es denkbar, dass die Plan-Daten mithilfe eines Computerprogramms, beispielsweise automatisiert oder durch einen Nutzer, erzeugt wurden und Informationen zu den in Kombination vorhandenen Zutrittskomponenten, beispielsweise in Textform oder als Listen, aufweisen. Erfindungsgemäß kommen eine Vielzahl unterschiedlicher Arten und Formate für die Plan-Daten infrage.

Das erfindungsgemäße Verfahren ist insbesondere ein computerimplementiertes Verfahren, bei dem ein, mehrere oder alle Schritte des Verfahrens computerimplementiert ausgeführt werden.

Gemäß einer Ausführungsform der vorliegenden Erfindung kann unter einem Zutrittssystem ein Vereinzelungs- und/oder Türsystem verstanden werden. Gemäß einer Ausführungsform der vorliegenden Erfindung kann unter einer Zutrittskomponente insbesondere ein Subsystem eines Zutrittssystems verstanden werden. Es ist gemäß einer Ausführungsform der vorliegenden Erfindung denkbar, dass ein Zutrittssystem eine Kombination aus einer, mehreren oder allen der folgenden Zutrittskomponenten umfasst:
- ein Türelement und/oder ein Vereinzelungselement,
- ein Scharnier,
- ein Brandschutzelement,
- ein Schloss, insbesondere ein elektrisches Schloss,
- eine Öffnungs- und/oder Schließvorrichtung für ein Türelement, insbesondere umfassend einen Aktuator und/oder Motor,
- eine Personenkontroll- und/oder Identitätskontrolleinrichtung, insbesondere ein Lesegerät für einen Pass,
- eine Zutrittskontrolleinrichtung, insbesondere eine Code- oder Passwortkontrolle,
- einen biometrischen Sensor,
- einen optischen Sensor,
- einen akustischen Sensor,
- eine elektrische Strom- und/oder Spannungsversorgung,
- eine Anzeigeeinrichtung,
- ein Leuchtmittel,
- eine akustische Ausgabevorrichtung,
- eine Warn- und/oder Sicherheitsvorrichtung,
- eine Eingabevorrichtung und/oder ein Betätigungselement, beispielsweise ein Druckknopf oder ein Touchpad,
- eine Steuerungsvorrichtung.

Es ist denkbar, dass die Steuerungsvorrichtung zur Ansteuerung von Zutrittskomponenten des Zutrittssystems und/oder zur Konfiguration von Zutrittskomponenten des Zutrittssystems ausgebildet ist.

Gemäß einer Ausführungsform der vorliegenden Erfindung ist es denkbar, dass das Zutrittssystem eines der folgenden Türsysteme und/oder Vereinzelungssysteme ist:
- eine Drehtür,
- eine Drehflügeltür,
- eine Karusselltür,
- eine Sicherheitskarusselltür,
- eine Personenschleuse,
- eine Schiebetür,
- eine Faltschiebetür,
- eine Drehsperre,
- ein Drehkreuz,
- eine Schwenktür.

Das ML-System kann gemäß einer Ausführungsform der vorliegenden Erfindung auch als KI (künstliche Intelligenz)-System verstanden werden. Es ist denkbar, dass das ML-System als Deep-Learning-System ausgebildet ist. Es kann beispielsweise mithilfe eines neuronalen Netzes gebildet sein.

Vorteilhafte Weiterbildungen und Ausgestaltungen der vorliegenden Erfindung können den abhängigen Ansprüchen entnommen werden.

Gemäß einer Ausführungsform der vorliegenden Erfindung ist es vorgesehen, dass das Verfahren ferner umfasst:
--- a3) Ausgeben des mindestens einen Veränderungsvorschlags, betreffend die eine oder die mehreren Zutrittskomponenten des mindestens einen Zutrittssystems, in Abhängigkeit der in Schritt a2) durchgeführten Analyse. Der Veränderungsvorschlag kann somit einem Nutzer bereitgestellt werden. Das Ausgeben des Veränderungsvorschlags kann beispielsweise innerhalb einer Computersoftware für Gebäudeplanungen erfolgen, wobei der Veränderungsvorschlag einem Nutzer durch die Computersoftware angezeigt wird, beispielsweise auf einem Computerbildschirm. Gemäß einer Ausführungsform der vorliegenden Erfindung ist es denkbar, dass alternativ oder zusätzlich zu Schritt a3)
--- ein Ergänzen und/oder Ändern der Plan-Daten durch den mindestens einen Veränderungsvorschlag, betreffend eine oder mehrere der Zutrittskomponenten des mindestens einen Zutrittssystems, in Abhängigkeit der in Schritt a2) durchgeführten Analyse erfolgt. Es ist denkbar, dass die Plan-Daten durch den mindestens einen Veränderungsvorschlag automatisiert geändert werden.

Gemäß einer Ausführungsform der vorliegenden Erfindung ist es vorgesehen, dass das Analysieren in Schritt a2) umfasst:
--- Vorhersagen von Problemen, betreffend die Kombination von Zutrittskomponenten des mindestens einen Zutrittssystems, durch das ML-System,
vorzugsweise wobei die vorhergesagten Probleme eines, mehrere oder alle der folgenden Probleme betreffen:
   - eine durch das ML-System vorhergesagte erhöhte Abnutzung des Zutrittssystems oder von einer oder mehreren der Zutrittskomponenten des Zutrittssystems; und/oder
   - eine durch das ML-System vorhergesagte erhöhte Fehleranfälligkeit des Zutrittssystems oder von einer oder mehreren der Zutrittskomponenten des Zutrittssystems; und/oder
   - ein durch das ML-System vorhergesagter erhöhter Wartungsaufwand des Zutrittssystems oder von einer oder mehreren der Zutrittskomponenten des Zutrittssystems; und/oder
   - eine durch das ML-System vorhergesagte verringerte Lebenszeit des Zutrittssystems oder von einer oder mehreren der Zutrittskomponenten des Zutrittssystems; und/oder
   - ein durch das ML-System vorhergesagter erhöhter elektrischer Energiebedarf des Zutrittssystems oder von einer oder mehreren der Zutrittskomponenten des Zutrittssystems. Die vorhergesagten Probleme betreffen dabei vorzugsweise die spezifische vorhandene Kombination von Zutrittskomponenten des Zutrittssystems. Es ist in vorteilhafter Weise denkbar, dass das ML-System in Schritt a2) den mindestens einen Veränderungsvorschlag in Abhängigkeit der vorhergesagten Probleme der Kombination von Zutrittskomponenten des mindestens einen Zutrittssystems erzeugt. Das ML-System ist vorzugsweise zur Berücksichtigung der vorgenannten Probleme beim Analysieren der Plan-Daten und beim Erzeugen des mindestens einen Veränderungsvorschlags trainiert.

Gemäß einer Ausführungsform der vorliegenden Erfindung ist es vorgesehen, dass das ML-System in Schritt a2) den mindestens einen Veränderungsvorschlag unter Berücksichtigung eines, mehrerer oder aller der folgenden Eigenschaften und/oder Parameter erzeugt:
- eine von dem ML-System erwartete Abnutzung des Zutrittssystems oder einer oder mehrerer Zutrittskomponenten des Zutrittssystems; und/oder
- ein von dem ML-System erwarteter Wartungsaufwands des Zutrittssystems oder einer oder mehrerer Zutrittskomponenten des Zutrittssystems; und/oder
- eine von dem ML-System erwartete Lebensdauer des Zutrittssystems oder einer oder mehrerer Zutrittskomponenten des Zutrittssystems; und/oder
- eine von dem ML-System erwartete Fehleranfälligkeit des Zutrittssystems oder einer oder mehrerer Zutrittskomponenten des Zutrittssystems; und/oder
- ein von dem ML-System erwarteter elektrischer Energiebedarf des Zutrittssystems oder einer oder mehrerer Zutrittskomponenten des Zutrittssystems,

vorzugsweise jeweils bezüglich einer bestimmten Kombination von Zutrittskomponenten. Insbesondere ist es somit denkbar, dass das ML-System bei der Erzeugung des Veränderungsvorschlags:
   - eine durch das ML-System vorhergesagte Veränderung der Abnutzung des Zutrittssystems oder einer oder mehrerer Zutrittskomponenten des Zutrittssystems; und/oder
   - eine durch das ML-System vorhergesagte Veränderung des Wartungsaufwands des Zutrittssystems oder einer oder mehrerer Zutrittskomponenten des Zutrittssystems; und/oder
   - eine durch das ML-System vorhergesagte Veränderung der Lebensdauer des Zutrittssystems oder einer oder mehrerer Zutrittskomponenten des Zutrittssystems; und/oder
   - eine durch das ML-System vorhergesagte Veränderung der Fehleranfälligkeit des Zutrittssystems oder einer oder mehrerer Zutrittskomponenten des Zutrittssystems; und/oder
   - eine durch das ML-System vorhergesagte Veränderung des elektrischen Energiebedarfs des Zutrittssystems oder einer oder mehrerer Zutrittskomponenten des Zutrittssystems
      berücksichtigt,
die durch den Veränderungsvorschlag erreicht werden. Das ML-System nimmt somit vorzugsweise eine Optimierung bezüglich der erwarteten Abnutzung, der erwarteten Lebensdauer, der erwarteten Fehleranfälligkeit, des erwarteten Wartungsaufwands und/oder des erwarteten elektrischen Energiebedarfs oder Leistungsbedarfs vor.

Gemäß einer Ausführungsform der vorliegenden Erfindung ist es vorgesehen, dass das ML-System in Schritt a2) den mindestens einen Veränderungsvorschlag unter Berücksichtigung einer erwarteten Lieferzeit von Zutrittskomponenten und/oder einer Verfügbarkeit von Zutrittskomponenten erzeugt. Hierdurch kann das ML-System eine aktuelle Verfügbarkeit und/oder typische Lieferzeit einer Zutrittskomponente, die das ML-System als Teil des Veränderungsvorschlags als Austauchteil für eine der aktuell verbauten Zutrittskomponenten des Zutrittssystem vorschlägt, berücksichtigen. Das ML-System kann somit beispielsweise verhindern, dass es Veränderungsvorschläge ausgibt, die zu einer unnötigen oder langen Verzögerung von Umbaumaßnahmen führen würden. Es ist alternativ oder zusätzlich denkbar, dass das ML-System erwartete Kosten bei der Erzeugung des Veränderungsvorschlags berücksichtigt, insbesondere Kosten, die durch einen vorgeschlagenen Austausch einer Zutrittskomponente oder durch eine Anpassung von Parametern einer Zutrittskomponente entstehen.

Gemäß einer Ausführungsform der vorliegenden Erfindung ist es vorgesehen, dass die in Schritt a1) durch das ML-System erhaltenen Plan-Daten eine, mehrere oder alle der folgenden Informationen aufweisen:
- architektonische Informationen, insbesondere bezüglich eines vorhandenen Bauraums für das Zutrittssystem oder für Zutrittskomponenten des Zutrittssystems; und/oder
- Sicherheitsanforderungsinformationen, betreffend Sicherheitsanforderungen an das Zutrittssystem oder an Zutrittskomponenten des Zutrittssystems; und/oder
- Benutzungsfrequenzinformationen, betreffend eine erwartete Benutzungsfrequenz des Zutrittssystems oder von Zutrittskomponenten des Zutrittssystems.

Gemäß einer Ausführungsform der vorliegenden Erfindung ist es vorgesehen, dass das ML-System in Schritt a2) den mindestens einen Veränderungsvorschlag unter Berücksichtigung:
- der architektonischen Informationen; und/oder
- der Sicherheitsanforderungsinformationen; und/oder
- der Benutzungsfrequenzinformationen
erzeugt. Somit kann das ML-System bei der Erzeugung des Veränderungsvorschlags, beispielsweise beim Vorschlagen einer Austauschzutrittskomponente für eine der vorhandenen Zutrittskomponenten, in vorteilhafter Weise die Anforderungen an das Zutrittssystem sowie die lokalen Bedingungen und Gegebenheiten berücksichtigen.

Gemäß einer Ausführungsform der vorliegenden Erfindung ist es vorgesehen, dass die Plan-Daten eine Bestandsimmobilie, insbesondere ein Bestandgebäude und/oder Bestandsareal, betreffen; und/oder
dass die Plan-Daten eine Änderungsplanung einer Bestandsimmobilie, insbesondere eines Bestandgebäudes und/oder Bestandsareals, betreffen. Die Plan-Daten sind beispielswiese dadurch bekannt, dass die Plan-Daten beim Bau der Bestandsimmobilie erzeugt wurden und potentielle Änderungen über die Lebenszeit der Bestandsimmobilie in den Plan-Daten nachgehalten wurden. Es ist denkbar, dass die Plan-Daten durch Messungen oder Untersuchungen, beispielsweise durch Fotos oder Videos, an einer Bestandimmobilie, insbesondere einer Brownfield-Immobilie, durch einen Nutzer erzeugt wurden. Die Plan-Daten können als digitaler Datensatz verstanden werden. Schritt a2) umfasst somit vorzugsweise ein Analysieren der Plan-Daten mithilfe des trainierten ML-Systems zum Bereitstellen von Veränderungsvorschlägen, betreffend eine oder mehrere der Zutrittskomponenten des mindestens einen Zutrittssystems einer Bestandsimmobilie. Alternativ ist es gemäß einer Ausführungsform der vorliegenden Erfindung denkbar, dass die Plan-Daten eine in der Planungsphase befindliche Immobile betreffen. Solche Plan-Daten werden beispielswiese durch Fachplaner und/oder Architekten in der Planungsphase von Immobilien erzeugt.

Gemäß einer Ausführungsform der vorliegenden Erfindung ist es vorgesehen, dass der mindestens eine Veränderungsvorschlag einen oder mehrere der folgenden Veränderungsvorschläge betrifft:
- einen Austausch von einer oder mehreren Zutrittskomponenten des Zutrittssystems;
- eine Änderung eines Prüfungsintervalls und/oder Wartungsintervalls des Zutrittssystems und/oder von einer oder mehreren Zutrittskomponenten des Zutrittssystems;
- eine Änderung von mechanischen, hydraulischen und/oder elektrischen Parametern des Zutrittssystems und/oder von einer oder mehreren Zutrittskomponenten des Zutrittssystems. Der Veränderungsvorschlag kann somit insbesondere ein Vorschlag zum Austausch einer im Zutrittssystem vorhandenen Zutrittskomponente durch eine andere Zutrittskomponente sein. Beispielsweise könnte das ML-System in Abhängigkeit seiner Analyse in Schritt a2) vorschlagen, ein im Zutrittssystem vorhandenes Scharnier durch einen anderen Scharniertyp auszutauschen, um die erwartete Lebenszeit eines Motors des Zutrittssystems zu verlängern. Das ML-System ist insbesondere zur Identifizierung derartiger Abhängigkeiten zwischen den einzelnen Zutrittskomponenten eines Zutrittssystems trainiert und gibt entsprechende Veränderungsvorschläge aus. Die Änderung eines mechanischen Parameters des Zutrittssystems und/oder von einer oder mehreren Zutrittskomponenten des Zutrittssystems kann beispielsweise mechanische Veränderungen am Türscharnier, ein Nachstellen von Schrauben oder Ähnliches umfassen. Die Abwandlung/Änderung von einzelnen Zutrittskomponenten könnte beispielsweise eine Veränderung des Türschließers betreffen. Es sind generell eine Vielzahl unterschiedlicher Veränderungen und Anpassungen denkbar, wobei das ML-System derart konfiguriert ist, dass es vorteilhafte Änderungsmöglichkeiten identifiziert und vorschlägt.

Ein weiterer Gegenstand der vorliegenden Erfindung ist ein Verfahren zum Trainieren eines ML-Systems, insbesondere zur Verwendung des trainierten ML-Systems in einem Verfahren zum Erzeugen von Veränderungsvorschlägen gemäß einer Ausführungsform der vorliegenden Erfindung,
wobei das Verfahren zum Trainieren des ML-Systems die folgenden Schritte umfasst:
--- b1) Ermitteln und/oder Bereitstellen von Trainingsdaten zum Trainieren des ML-Systems,
--- b2) Trainieren des ML-Systems mithilfe der Trainingsdaten zum Erzeugen von Veränderungsvorschlägen, betreffend eine oder mehrere Zutrittskomponenten eines Zutrittssystems. Das erfindungsgemäß trainierte ML-System ist insbesondere in den Schritten a1), a2) und optional a3) verwendbar.

Gemäß einer Ausführungsform der vorliegenden Erfindung ist es vorgesehen, dass die Trainingsdaten:
- Kombinationen von Zutrittskomponenten von Zutrittssystemen und
- in der Anwendung der Kombinationen von Zutrittskomponenten ermittelte Fehler, Abnutzungserscheinungen, Probleme und/oder Eigenschaften betreffen. Die Trainingsdaten stammen vorzugsweise aus der Wartung und/oder Kontrolle und/oder Prüfung realer, in der Anwendung verwendeter Zutrittssysteme Es existiert in der Praxis eine große Vielzahl an verbauten Zutrittssystemen, die gewartet werden und/oder an denen Reparaturen vorgenommen werden. Durch ein Nachhalten der in der Praxis auftretenden Fehler und Probleme, die im Zuge solcher Wartungsarbeiten oder Reparaturarbeiten identifiziert werden, und ein Verknüpfen der aufgetreten Fehler und Probleme mit Informationen zu den jeweils in Kombination verwendeten Zutrittskomponenten der Zutrittssysteme, an denen die Fehler und Probleme aufgetreten sind, kann eine äußerst umfangreiche Datenbasis erzeugt werden, die zum Trainieren des ML-Systems verwendet werden kann. Es kann daher mit geringem Aufwand ein umfangreicher Trainingsdatensatz erzeugt werden, in dem Informationen zu den Fehlern, Abnutzungserscheinungen, Problemen und/oder Eigenschaften enthalten sind, die in der Wartung und/oder Kontrolle und/oder Prüfung realer Zutrittssysteme ermittelt wurden. Das ML-System kann anhand eines solchen Trainingsdatensatzes dazu trainiert werden, Problem zu ermitteln, die durch die Verwendung bestimmter Kombinationen von Zutrittskomponenten auftreten, und die beispielsweise durch Fachpersonal nicht unbedingt eigenständig identifizierbar wären. Das trainierte ML-System kann solche potentiellen Probleme in Plan-Daten, die Informationen zu bestimmten Kombinationen von Zutrittssystemen aufweisen, identifizieren und Änderungen vorschlagen, um die potentiellen Probleme zu verringern.

Gemäß einer Ausführungsform der vorliegenden Erfindung ist es denkbar, dass die Trainingsdaten
- Informationen zu den Maßen und/oder dem benötigten Bauraum von Zutrittskomponenten und/oder Zutrittssystemen; und/oder
- Informationen zu den Sicherheitsanforderungen, die Zutrittskomponenten und/oder Zutrittssysteme erfüllen; und/oder
- Informationen zu Benutzungsfrequenzen, für die die Zutrittskomponenten und/oder Zutrittssysteme ausgelegt sind,
enthalten.

Gemäß einer Ausführungsform der vorliegenden Erfindung ist es vorgesehen, dass das ML-System in Schritt b2) zur Erkennung und/oder Vorhersage von Problemen, betreffend Kombinationen von Zutrittskomponenten von Zutrittssystemen, trainiert wird. Das erfindungsgemäße Verfahren umfasst somit vorzugsweise ein Verfahren zum Trainieren eines ML-Systems zur Erkennung und/oder Vorhersage von Problemen, betreffend Kombinationen von Zutrittskomponenten von Zutrittssystemen. Die Probleme, betreffend Kombinationen von Zutrittskomponenten von Zutrittssystemen, können insbesondere eines, mehrere oder alle der folgenden Probleme sein:
- eine erhöhte Abnutzung des Zutrittssystems oder von einer oder mehreren der Zutrittskomponenten des Zutrittssystems; und/oder
- eine erhöhte Fehleranfälligkeit des Zutrittssystems oder von einer oder mehreren der Zutrittskomponenten des Zutrittssystems; und/oder
- ein erhöhter Wartungsaufwand des Zutrittssystems oder von einer oder mehreren der Zutrittskomponenten des Zutrittssystems; und/oder
- eine verringerte Lebenszeit des Zutrittssystems oder von einer oder mehreren der Zutrittskomponenten des Zutrittssystems; und/oder
- ein erhöhter elektrischer Energiebedarf des Zutrittssystems oder von einer oder mehreren der Zutrittskomponenten des Zutrittssystems. Derartige Probleme sind insbesondere durch die jeweils verwendete Kombination von Zutrittskomponenten des Zutrittssystems bedingt.

Gemäß einer Ausführungsform der vorliegenden Erfindung ist es vorgesehen, dass das ML-System in Schritt b2) zum Erzeugen der Veränderungsvorschläge, betreffend eine oder mehrere Zutrittskomponenten eines Zutrittssystems, in Abhängigkeit von erkannten und/oder vorhergesagten Problemen für Kombinationen von Zutrittskomponenten trainiert wird.

Gemäß einer Ausführungsform der vorliegenden Erfindung ist es vorgesehen, dass die Trainingsdaten:
- Zutrittskomponenteninformationen, betreffend die in Kombination verwendeten Zutrittskomponenten von Zutrittssystemen; und
- Labelinformationen, betreffend in der Anwendung der in Kombination verwendeten Zutrittskomponenten ermittelte Fehler, Probleme, Abnutzungserscheinungen, und/oder Eigenschaften
   umfassen,

wobei in Schritt b2) mithilfe der Zutrittskomponenteninformationen und Labelinformationen ein überwachtes Lernen zum Training des ML-Systems durchgeführt wird. Es kann somit ein vorteilhaftes überwachtes Lernen mithilfe von Labeln bzw. Labelinformationen erfolgen, die die in der Anwendung ermittelten Fehler, Probleme, Abnutzungserscheinungen, und/oder
Eigenschaften von in Kombination verwendeten Zutrittskomponenten aufweisen. Diese Labelinformationen können auf Erfahrungswerten beruhen, die sich in der Wartung und der Reparatur einer Vielzahl von Zutrittssystemen ergeben haben. Auch Methoden des bestärkenden Lernens oder unüberwachten Lernens sind zum Training des ML-Systems denkbar.

Ein weiterer Gegenstand der vorliegenden Erfindung ist ein Computersystem, aufweisend ein ML-System, wobei das Computersystem zum Ausführen eines Verfahrens gemäß einer Ausführungsform der vorliegenden Erfindung konfiguriert ist. Insbesondere umfasst das Computersystem Computermittel, die zur Ausführung eines Verfahrens gemäß einer Ausführungsform der vorliegenden Erfindung konfiguriert sind. Gemäß einer Ausführungsform der vorliegenden Erfindung, ist das Computersystem zumindest zur Ausführung der Schritte a1) und a2) konfiguriert, wobei das Computersystem optional zur Ausführung des Schritts a3) konfiguriert ist.

Ein weiterer Gegenstand der vorliegenden Erfindung sind Trainingsdaten zur Verwendung in einem Verfahren zum Trainieren eines ML-Systems gemäß einer Ausführungsform der vorliegenden Erfindung,
wobei die Trainingsdaten:
- Kombinationen von Zutrittskomponenten von Zutrittssystemen und
- in der Anwendung der Kombinationen von Zutrittskomponenten ermittelte Fehler, Abnutzungserscheinungen, Probleme und/oder Eigenschaften betreffen. Die Trainingsdaten sind somit zum Trainieren eines ML-Systems zum Bereitstellen von Veränderungsvorschlägen, betreffend eine oder mehrere Zutrittskomponenten eines Zutrittssystems, vorgesehen und/oder konfiguriert. Die Trainingsdaten stammen vorzugsweise aus der Wartung und Reparatur in der Anwendung befindlicher Zutrittssysteme.

Ein weiterer Gegenstand der vorliegenden Erfindung ist ein Computerprogrammprodukt, umfassend Befehle, die bei der Ausführung durch ein Computersystem, dieses veranlassen, ein Verfahren gemäß einer Ausführungsform der vorliegenden Erfindung durchzuführen.

Die Merkmale, Ausführungsformen und Vorteile, die im Zusammenhang mit einem der erfindungsgemäßen Gegenstände beschrieben worden sind, können jeweils auch für die weiteren erfindungsgemäßen Gegenstände Anwendung finden. Insbesondere können für das erfindungsgemäße Computersystem, die erfindungsgemäßen Trainingsdaten und das erfindungsgemäße Computerprogrammprodukt dabei die Merkmale, Ausführungsformen und Vorteile Anwendung finden, die bereits im Zusammenhang mit dem erfindungsgemäßen Verfahren zum Erzeugen von Veränderungsvorschlägen oder im Zusammenhang mit einer Ausführungsform des erfindungsgemäßen Verfahrens zum Erzeugen von Veränderungsvorschlägen beschrieben worden sind. Ferner können für das erfindungsgemäße Computersystem, die erfindungsgemäßen Trainingsdaten und das erfindungsgemäße Computerprogrammprodukt dabei die Merkmale, Ausführungsformen und Vorteile Anwendung finden, die bereits im Zusammenhang mit dem erfindungsgemäßen Verfahren zum Trainieren eines ML-Systems oder im Zusammenhang mit einer Ausführungsform des erfindungsgemäßen Verfahrens zum Trainieren eines ML-Systems beschrieben worden sind.

Nachfolgend sollen weitere Vorteile und Einzelheiten der Erfindung anhand der in den Zeichnungen dargestellten Ausführungsbeispiele erläutert werden. Hierin zeigen
- Fig. 1A: eine schematische Darstellung eines Zutrittssystems gemäß einem Ausführungsbeispiel der vorliegenden Erfindung;
- Fig. 1B: eine schematische Darstellung einer Immobilie gemäß einem Ausführungsbeispiel der vorliegenden Erfindung;
- Fig. 2: eine schematische Darstellung eines Computersystems gemäß einem Ausführungsbeispiel der vorliegenden Erfindung;
- Fig. 3A: eine schematische Darstellung eines Verfahrens zum Erzeugen von Veränderungsvorschlägen gemäß einem Ausführungsbeispiel der vorliegenden Erfindung;
- Fig. 3B: eine schematische Darstellung eines Verfahrens zum Trainieren eines ML-Systems gemäß einem Ausführungsbeispiel der vorliegenden Erfindung;
- Fig. 4 bis 6: jeweils schematische Darstellungen von Verfahren gemäß Ausführungsbeispielen der vorliegenden Erfindung.

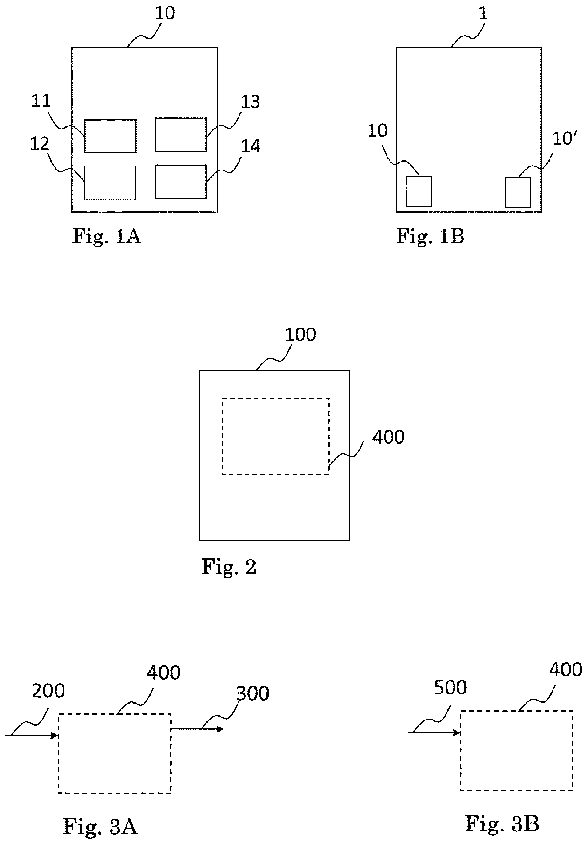

In Fig. 1A ist eine schematische Blockdarstellung eines Zutrittssystems 10 gemäß einem Ausführungsbeispiel der vorliegenden Erfindung gezeigt. Das Zutrittssystem 10 ist vorzugsweise als Türsystem oder Vereinzelungssystem ausgebildet und in einem Gebäude oder Areal verbaut. Das Zutrittssystem 10 umfasst mehrere Zutrittskomponenten 11, 12, 13, 14, die auch als Untersysteme oder Bauteile des Zutrittssystems 10 verstanden werden können. Beispielsweise umfassen die Zutrittskomponenten 11, 12, 13, 14 eine oder mehrere der folgenden Komponenten:
- ein Türelement und/oder ein Vereinzelungselement,
- ein Scharnier,
- ein Brandschutzelement,
- ein Schloss, insbesondere ein elektrisches Schloss,
- eine Öffnungs- und/oder Schließvorrichtung für ein Türelement, insbesondere umfassend einen Aktuator und/oder Motor,
- eine Personenkontroll- und/oder Identitätskontrolleinrichtung, insbesondere ein Lesegerät für einen Pass,
- eine Zutrittskontrolleinrichtung, insbesondere eine Code- oder Passwortkontrolle,
- einen biometrischen Sensor,
- einen optischen Sensor,
- einen akustischen Sensor,
- eine elektrische Strom- und/oder Spannungsversorgung,
- eine Anzeigeeinrichtung,
- ein Leuchtmittel,
- eine akustische Ausgabevorrichtung,
- eine Warn- und/oder Sicherheitsvorrichtung,
- eine Eingabevorrichtung und/oder ein Betätigungselement, beispielsweise ein Druckknopf oder ein Touchpad,
- eine Steuerungsvorrichtung. Es ist denkbar, dass die Steuerungsvorrichtung als Zutrittskomponente des Zutrittssystem 10 ausgebildet ist oder dass die Steuerungsvorrichtung extern von dem Zutrittssystem 10 ausgebildet ist. Die Steuerungsvorrichtung ist zur Ansteuerung von einer oder mehreren der Zutrittskomponenten 11, 12, 13, 14 konfiguriert und beispielsweise über eine drahtlose und/oder drahtgebundene Verbindung zur Kommunikation mit diesen Zutrittskomponenten eingerichtet. Beispielsweise ist ein Bus-System zwischen der Steuerungsvorrichtung 12 und einzelnen Zutrittskomponenten oder zwischen der Steuerungsvorrichtung 12 und dem Zutrittssystem ausgebildet.

In Fig, 1B ist eine schematische Darstellung einer Immobilie 1, insbesondere eines Gebäudes, gezeigt, die eine Zutrittssystem 10 gemäß einer Ausführungsform der vorliegenden Erfindung aufweist. Zusätzlich zu dem Zutrittssystem 10 kann die Immobilie eine oder mehrere weitere Zutrittssysteme 10' aufweisen.

In Fig, 2 ist eine schematische Darstellung eines Computersystems 100 gemäß einer Ausführungsform der vorliegenden Erfindung gezeigt. Das Computersystems 100 stellt ein ML-System 400 bereit, mit dessen Hilfe Veränderungsvorschläge 300, betreffend eine oder mehrere Zutrittskomponenten 11, 12, 13, 14 eines Zutrittssystems 10 bereitgestellt werden können. Das Computersystem 100 kann dabei eine oder mehrere physische Computereinrichtungen umfassen. Es ist denkbar, dass das Computersystem 100 mithilfe einer Cloud ausgebildet ist.

In Fig, 3A ist eine schematische Darstellung eines Verfahrens zum Erzeugen von Veränderungsvorschlägen 300, betreffend eine oder mehrere Zutrittskomponenten 11, 12, 13, 14 eines Zutrittssystems 10, gemäß einer Ausführungsform der vorliegenden Erfindung gezeigt. Ein ML-System 400 erhält Plan-Daten 200 einer Immobilie, insbesondere einer Bestandsimmobilie, wobei die Plan-Daten 200 Informationen zu mindestens einem Zutrittssystem 10 der Immobilie 1 enthalten, in denen die Zutrittskomponenten 11, 12, 13, 14 bezeichnet sind, die das Zutrittssystem 10 aufweist. Die Plan-Daten 200 werden dem ML-System in digitaler Form bereitgestellt. Vorzugsweise bilden die Plan-Daten 200 den aktuell in der Immobilie 1 verbauten Zustand des Zutrittssystems 10 und/oder die aktuell verbaute Kombination von Zutrittskomponenten 11, 12, 13, 14 des Zutrittssystems 10 ab. Es ist alternativ oder zusätzlich denkbar, dass die Plan-Daten Informationen zu einer Änderungsplanung, betreffend das aktuell verbaute Zutrittssystem 10 und/oder eine oder mehrere der Zutrittskomponenten des aktuell verbauten Zutrittssystem 10, umfassen. Solche Änderungsplanungen können beispielsweise durch Fachpersonal erstellt worden sein und in den Plan-Daten 200 abgebildet sein. Das ML-System 400 ist zur Analyse der Plan-Daten 200 trainiert und erzeugt einen Veränderungsvorschlag 300, betreffend eine oder mehrere der Zutrittskomponenten 11, 12, 13, 14 des Zutrittssystems 10. Der Veränderungsvorschlag 300 kann durch das ML-System 400 ausgeben werden und beispielsweise einem Nutzer oder Fachplaner angezeigt oder mitgeteilt werden.

In Fig, 3B ist eine schematische Darstellung eines Verfahrens
zum Trainieren eines ML-Systems 400 gemäß einer Ausführungsform der vorliegenden Erfindung gezeigt. Das ML-System 400 wird durch bereitgestellte Trainingsdaten 500 trainiert. Die Trainingsdaten 500 werden durch Messungen, Reparaturarbeiten und/oder Wartungsarbeiten an einer Vielzahl von realen Türsystemen erhalten und umfassen Informationen:
- zu den jeweils in diesen Zutrittssystemen in Kombinationen verwendeten Zutrittskomponenten 11, 12, 13, 14 und
- zu Fehlern, Abnutzungserscheinungen, Problemen und/oder Eigenschaften, die jeweils durch die Messungen, Reparaturarbeiten und/oder Wartungsarbeiten der Vielzahl von realen Türsystemen ermittelt wurden. Durch die Vielzahl an realen Türsystemen, an denen in der Praxis regelmäßig oder unregelmäßig Reparaturen und Wartungen durchgeführt werden, kann somit eine breite Datenbasis für das Training des ML-Systems 400 erzeugt werden. Das ML-System 400 wird auf diese Weise zum Erzeugen von Veränderungsvorschlägen 300, betreffend eine oder mehrere Zutrittskomponenten 11, 12, 13, 14 eines Zutrittssystems 10, trainiert. Das Trainieren des ML-Systems 400 kann dabei auch kontinuierlich durchgeführt werden, sodass das ML-System 400 weiter trainiert werden kann, wenn es sich bereits in der Anwendung befindet.

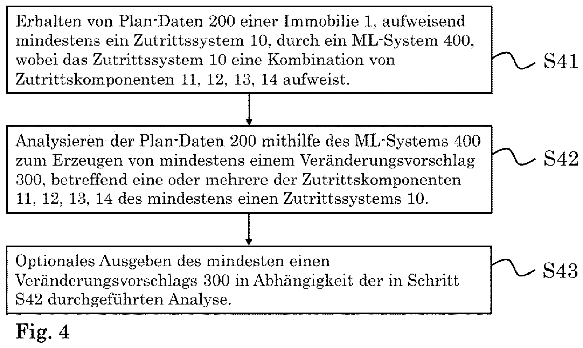

In Fig. 4 ist eine schematische Darstellung eines Verfahrens zum Erzeugen von Veränderungsvorschlägen 300 gemäß einer Ausführungsform der vorliegenden Erfindung gezeigt. In einem Schritt S41 werden Plan-Daten 200 einer Immobilie 1, aufweisend mindestens ein Zutrittssystem 10, durch ein ML-System 400 erhalten, wobei das Zutrittssystem 10 eine Kombination von Zutrittskomponenten 11, 12, 13, 14 aufweist. In S42 erfolgt ein Analysieren der Plan-Daten 200 mithilfe des ML-Systems 400 zum Erzeugen von mindestens einem Veränderungsvorschlag 300, betreffend eine oder mehrere der Zutrittskomponenten 11, 12, 13, 14 des mindestens einen Zutrittssystems 10. Das Analysieren in Schritt S42 umfasst vorzugsweise ein Vorhersagen von Problemen, betreffend die in den Plan-Daten 200 enthaltene Kombination von Zutrittskomponenten 11, 12, 13, 14 des mindestens einen Zutrittssystems 10, durch das ML-System 400. Die durch das ML-System 400 vorhergesagten Probleme sind dabei vorzugsweise eines, mehrere oder alle der folgenden Probleme für die spezifische, in den Plan-Daten enthaltene Kombination von Zutrittskomponenten 11, 12, 13, 14:
- eine durch das ML-System 400 vorhergesagte erhöhte Abnutzung des Zutrittssystems 10 oder von einer oder mehreren der Zutrittskomponenten 11, 12, 13, 14 des Zutrittssystems 10; und/oder
- eine durch das ML-System 400 vorhergesagte erhöhte Fehleranfälligkeit des Zutrittssystems 10 oder von einer oder mehreren der Zutrittskomponenten 11, 12, 13, 14 des Zutrittssystems 10; und/oder
- ein durch das ML-System 400 vorhergesagter erhöhter Wartungsaufwand des Zutrittssystems 10 oder von einer oder mehreren der Zutrittskomponenten 11, 12, 13, 14 des Zutrittssystems 10; und/oder
- eine durch das ML-System 400 vorhergesagte verringerte Lebenszeit des Zutrittssystems 10 oder von einer oder mehreren der Zutrittskomponenten 11, 12, 13, 14 des Zutrittssystems 10; und/oder
- ein durch das ML-System 400 vorhergesagter erhöhter elektrischer Energiebedarf des Zutrittssystems 10 oder von einer oder mehreren der Zutrittskomponenten 11, 12, 13, 14 des Zutrittssystems 10.

Das ML-System 400 erzeugt vorzugsweise einen Veränderungsvorschlag 300, der die vorhergesagten Probleme verringert.

Es ist denkbar, dass das ML-System 400 bei der Erzeugung des Veränderungsvorschlags eine erwartete Lieferzeit und/oder Verfügbarkeit von einzelnen Zutrittskomponenten 11, 12, 13, 14, die es als alternative Austauschkomponenten vorschlägt, berücksichtigt.

Der mindestens eine von dem ML-System 400 erzeugte Veränderungsvorschlag 300 umfasst dabei einen oder mehrere der folgenden Veränderungsvorschläge 300:
- einen Austausch von einer oder mehrerer der in den Plan-Daten 200 enthaltenen Zutrittskomponenten 11, 12, 13, 14 des Zutrittssystems 10 durch eine oder mehrere alternative Zutrittskomponenten 11, 12, 13, 14, beispielsweise ein alternatives Modell einer Zutrittskomponente;
- eine Änderung eines Prüfungsintervalls und/oder Wartungsintervalls des Zutrittssystems 10 und/oder von einer oder mehreren Zutrittskomponenten 11, 12, 13, 14 des Zutrittssystems 10;
- eine Änderung von mechanischen, hydraulischen und/oder elektrischen Parametern des Zutrittssystems 10 und/oder von einer oder mehreren Zutrittskomponenten 11, 12, 13, 14 des Zutrittssystems 10.

In Schritt S43 erfolgt ein optionales Ausgeben des mindestens einen Veränderungsvorschlags 300 in Abhängigkeit der in Schritt S42 durchgeführten Analyse. Insbesondere wird der in Schritt S42 erzeugte mindestens eine Veränderungsvorschlag 300 ausgegeben und derart einem Nutzer zur Verfügung gestellt. Das Ausgeben des Veränderungsvorschlags 300 kann beispielsweise optisch über einen Computerbildschirm des Computersystems 100 erfolgen.

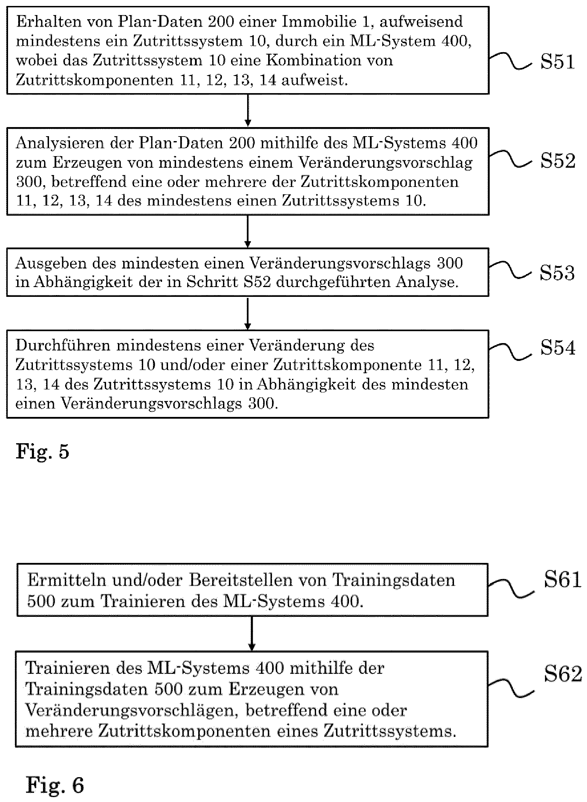

In Fig. 5 ist eine schematische Darstellung eines Verfahrens zum Erzeugen von Veränderungsvorschlägen 300 gemäß einer Ausführungsform der vorliegenden Erfindung gezeigt. Die Schritte S51, S52 und S53 entsprechen dabei vorzugsweise den Schritten S41, S42 und S43 gemäß der Fig. 4. Insbesondere werden in einem Schritt S51 Plan-Daten 200 einer Immobilie 1, aufweisend mindestens ein Zutrittssystem 10, durch ein ML-System 400 erhalten, wobei das Zutrittssystem 10 eine Kombination von Zutrittskomponenten 11, 12, 13, 14 aufweist. In S52 erfolgt ein Analysieren der Plan-Daten 200 mithilfe des ML-Systems 400 zum Erzeugen von mindestens einem Veränderungsvorschlag 300, betreffend eine oder mehrere der Zutrittskomponenten 11, 12, 13, 14 des mindestens einen Zutrittssystems 10. In Schritt S53 erfolgt ein optionales Ausgeben des mindestens einen Veränderungsvorschlags 300 in Abhängigkeit der in Schritt S52 durchgeführten Analyse. In einem Schritt S54 erfolgt ein Durchführen mindestens einer Veränderung des Zutrittssystems 10 und/oder einer Zutrittskomponente 11, 12, 13, 14 des Zutrittssystems 10 in Abhängigkeit des mindestens einen Veränderungsvorschlags 300. Der Veränderungsvorschlag 300 wird dabei vorzugsweise an dem verbauten Türsystem 10 der Immobilie 1 durchgeführt. Beispielsweise wird gemäß dem Veränderungsvorschlag 300 eine Zutrittskomponente 11, 12, 13, 14 durch eine von dem ML-System vorgeschlagene alternative Zutrittskomponente 11, 12, 13, 14, beispielsweise ein anderes Modell, ersetzt. Somit kann der Wartungsaufwand des realen Türsystems 10 verringert werden und/oder die Lebenszeit erhöht werden und/oder der Energieverbrauch verringert.

In Fig. 6 ist eine schematische Darstellung eines Verfahrens
zum Trainieren eines ML-Systems 400 gemäß einer Ausführungsform der vorliegenden Erfindung gezeigt. In einem Schritt S61 erfolgt ein Ermitteln und/oder Bereitstellen von Trainingsdaten zum Trainieren des ML-Systems 400. Die Trainingsdaten kommen dabei vorzugsweise aus der Anwendung realer Zutrittssysteme und werden beispielsweise aus der alltäglichen Wartung und/oder Reparatur von Zutrittssystemen erhalten. In einem Schritt S62 erfolgt ein Trainieren des ML-Systems 400 mithilfe der Trainingsdaten 500 zum Erzeugen von Veränderungsvorschlägen, betreffend eine oder mehrere Zutrittskomponenten eines Zutrittssystems. Das derart trainierte ML-System 400 kann beispielsweise in einem Verfahren gemäß der Fig. 4 oder Fig. 5 verwendet werden.

Merkmale der in den Figuren 3A, 3B, 4, 5 und 6 dargestellten Ausführungsbeispiele können untereinander kombiniert werden.

### Bezugszeichenliste

- 1: Immobilie
- 10: Zutrittssystem
- 10': weiteres Zutrittssystem
- 11, 12, 13, 14: Zutrittskomponenten
- 100: Computersystem
- 200: Plan-Daten
- 300: Veränderungsvorschlag
- 400: ML-System
- 500: Trainingsdaten
- S41 - S43: Schritte
- S51 - S54: Schritte
- S61 - S62: Schritte

## Patentansprüche

1. Verfahren zum Erzeugen von Veränderungsvorschlägen (300), betreffend eine oder mehrere Zutrittskomponenten (11, 12, 13, 14) eines Zutrittssystems (10), mithilfe eines ML-Systems (400),
wobei das Verfahren zum Erzeugen von Veränderungsvorschlägen (300) umfasst:
--- a1) Erhalten von Plan-Daten (200) einer Immobilie (1), aufweisend mindestens ein Zutrittssystem (10), durch das ML-System (400),
wobei das Zutrittssystem (10) eine Kombination von Zutrittskomponenten (11, 12, 13, 14) aufweist,
--- a2) Analysieren der Plan-Daten (200) mithilfe des ML-Systems (400) zum Erzeugen von mindestens einem Veränderungsvorschlag (300), betreffend eine oder mehrere der Zutrittskomponenten (11, 12, 13, 14) des mindestens einen Zutrittssystems (10).

2. Verfahren nach Anspruch 1, wobei das Verfahren ferner umfasst:
--- a3) Ausgeben des mindesten einen Veränderungsvorschlags (300), betreffend die eine oder die mehreren Zutrittskomponenten (11, 12, 13, 14) des mindestens einen Zutrittssystems (10), in Abhängigkeit der in Schritt a2) durchgeführten Analyse.

3. Verfahren nach einem der vorhergehenden Ansprüche, wobei das Analysieren in Schritt a2) umfasst:
--- Vorhersagen von Problemen, betreffend die Kombination von Zutrittskomponenten (11, 12, 13, 14) des mindestens einen Zutrittssystems (10), durch das ML-System (400), vorzugsweise wobei die vorhergesagten Probleme eines, mehrere oder alle der folgenden Probleme betreffen:
- eine durch das ML-System (400) vorhergesagte erhöhte Abnutzung des Zutrittssystems (10) oder von einer oder mehreren der Zutrittskomponenten (11, 12, 13, 14) des Zutrittssystems (10); und/oder
- eine durch das ML-System (400) vorhergesagte erhöhte Fehleranfälligkeit des Zutrittssystems (10) oder von einer oder mehreren der Zutrittskomponenten (11, 12, 13, 14) des Zutrittssystems (10); und/oder
- ein durch das ML-System (400) vorhergesagter erhöhter Wartungsaufwand des Zutrittssystems (10) oder von einer oder mehreren der Zutrittskomponenten (11, 12, 13, 14) des Zutrittssystems (10); und/oder
- eine durch das ML-System (400) vorhergesagte verringerte Lebenszeit des Zutrittssystems (10) oder von einer oder mehreren der Zutrittskomponenten (11, 12, 13, 14) des Zutrittssystems (10); und/oder
- ein durch das ML-System (400) vorhergesagter erhöhter elektrischer Energiebedarf des Zutrittssystems (10) oder von einer oder mehreren der Zutrittskomponenten (11, 12, 13, 14) des Zutrittssystems (10).

4. Verfahren nach einem der vorhergehenden Ansprüche, wobei das ML-System (400) in Schritt a2) den mindestens einen Veränderungsvorschlag (300) unter Berücksichtigung eines, mehrerer oder aller der folgenden Eigenschaften und/oder Parameter erzeugt:
- eine von dem ML-System (400) erwartete Abnutzung des Zutrittssystems (10) oder einer oder mehrerer Zutrittskomponenten (11, 12, 13, 14) des Zutrittssystems (10); und/oder
- ein von dem ML-System (400) erwarteter Wartungsaufwands des Zutrittssystems (10) oder einer oder mehrerer Zutrittskomponenten (11, 12, 13, 14) des Zutrittssystems (10); und/oder
- eine von dem ML-System (400) erwartete Lebensdauer des Zutrittssystems (10) oder einer oder mehrerer Zutrittskomponenten (11, 12, 13, 14) des Zutrittssystems (10); und/oder
- eine von dem ML-System (400) erwartete Fehleranfälligkeit des Zutrittssystems (10) oder einer oder mehrerer Zutrittskomponenten (11, 12, 13, 14) des Zutrittssystems (10); und/oder
- ein von dem ML-System (400) erwarteter elektrischer Energiebedarf des Zutrittssystems (10) oder einer oder mehrerer Zutrittskomponenten (11, 12, 13, 14) des Zutrittssystems (10),
vorzugsweise jeweils bezüglich einer bestimmten Kombination von Zutrittskomponenten (11, 12, 13, 14).

5. Verfahren nach einem der vorhergehenden Ansprüche, wobei das ML-System (400) in Schritt a2) den mindestens einen Veränderungsvorschlag (300) unter Berücksichtigung einer erwarteten Lieferzeit von Zutrittskomponenten (11, 12, 13, 14) und/oder einer Verfügbarkeit von Zutrittskomponenten (11, 12, 13, 14) erzeugt.

6. Verfahren nach einem der vorhergehenden Ansprüche, wobei die Plan-Daten (200) eine Bestandsimmobilie, insbesondere ein Bestandgebäude und/oder Bestandsareal, betreffen; und/oder
wobei die Plan-Daten (200) eine Änderungsplanung einer Bestandsimmobilie, insbesondere eines Bestandgebäudes und/oder Bestandsareals, betreffen.

7. Verfahren nach einem der vorhergehenden Ansprüche, wobei der mindestens eine Veränderungsvorschlag (300) einen oder mehrere der folgenden Veränderungsvorschläge (300) betrifft:
- einen Austausch von einer oder mehreren Zutrittskomponenten (11, 12, 13, 14) des Zutrittssystems (10);
- eine Änderung eines Prüfungsintervalls und/oder Wartungsintervalls des Zutrittssystems (10) und/oder von einer oder mehreren Zutrittskomponenten (11, 12, 13, 14) des Zutrittssystems (10);
- eine Änderung von mechanischen, hydraulischen und/oder elektrischen Parametern des Zutrittssystems (10) und/oder von einer oder mehreren Zutrittskomponenten (11, 12, 13, 14) des Zutrittssystems (10).

8. Verfahren zum Trainieren eines ML-Systems (400), insbesondere zur Verwendung des trainierten ML-Systems (400) in einem Verfahren gemäß einem der vorhergehenden Ansprüche,
wobei das Verfahren zum Trainieren des ML-Systems (400) die folgenden Schritte umfasst:
--- b1) Ermitteln und/oder Bereitstellen von Trainingsdaten (500) zum Trainieren des ML-Systems (400),
--- b2) Trainieren des ML-Systems (400) mithilfe der Trainingsdaten (500) zum Erzeugen von Veränderungsvorschlägen (300), betreffend eine oder mehrere Zutrittskomponenten (11, 12, 13, 14) eines Zutrittssystems (10).

9. Verfahren nach Anspruch 8, wobei die Trainingsdaten (500):
- Kombinationen von Zutrittskomponenten (11, 12, 13, 14) von Zutrittssystemen (10) und
- in der Anwendung der Kombinationen von Zutrittskomponenten (11, 12, 13, 14) ermittelte Fehler, Abnutzungserscheinungen, Probleme und/oder Eigenschaften
betreffen.

10. Verfahren nach einem der Ansprüche 8 oder 9, wobei das ML-System (400) in Schritt b2) zur Erkennung und/oder Vorhersage von Problemen, betreffend Kombinationen von Zutrittskomponenten (11, 12, 13, 14) von Zutrittssystemen (10), trainiert wird.

11. Verfahren nach einem der Ansprüche 8 bis 10, wobei das ML-System (400) in Schritt b2) zum Erzeugen der Veränderungsvorschläge (300), betreffend eine oder mehrere Zutrittskomponenten (11, 12, 13, 14) eines Zutrittssystems (10), in Abhängigkeit von erkannten und/oder vorhergesagten Problemen für Kombinationen von Zutrittskomponenten (11, 12, 13, 14) trainiert wird.

12. Verfahren nach einem der Ansprüche 8 bis 11, wobei die Trainingsdaten (500):
- Zutrittskomponenteninformationen, betreffend die in Kombination verwendeten Zutrittskomponenten (11, 12, 13, 14) von Zutrittssystemen (10); und
- Labelinformationen, betreffend in der Anwendung der in Kombination verwendeten Zutrittskomponenten (11, 12, 13, 14) ermittelte Fehler, Probleme, Abnutzungserscheinungen, und/oder Eigenschaften
umfassen,
wobei in Schritt b2) mithilfe der Zutrittskomponenteninformationen und Labelinformationen ein überwachtes Lernen zum Training des ML-Systems (400) durchgeführt wird.

13. Computersystem (100), aufweisend ein ML-System (400), wobei das Computersystem zum Ausführen eines Verfahrens nach einem der vorhergehenden Ansprüche konfiguriert ist.

14. Trainingsdaten (500) zur Verwendung in einem Verfahren nach einem der Ansprüche 8 bis 12,
wobei die Trainingsdaten:
- Kombinationen von Zutrittskomponenten (11, 12, 13, 14) von Zutrittssystemen (10) und
- in der Anwendung der Kombinationen von Zutrittskomponenten (11, 12, 13, 14) ermittelte Fehler, Abnutzungserscheinungen, Probleme und/oder Eigenschaften
betreffen.

15. Computerprogrammprodukt, umfassend Befehle, die bei der Ausführung durch ein Computersystem, dieses veranlassen, ein Verfahren nach einem der Ansprüche 1 bis 12 durchzuführen.
